**Europäisches Patentamt**

**European Patent Office**

**Office européen des brevets**

(19)

(11) Publication number: **0 002 383**
**B1**

(12) # EUROPEAN PATENT SPECIFICATION

(45) Date of publication of patent specification: **28.07.82**

(51) Int. Cl.³: **C 23 C 11/00,**
**H 01 L 21/205**

(21) Application number: **78300737.0**

(22) Date of filing: **05.12.78**

(54) Method and apparatus for depositing semiconductor and other films.

(30) Priority: **05.12.77 US 857690**

(43) Date of publication of application:
**13.06.79 Bulletin 79/12**

(45) Publication of the grant of the patent:
**28.07.82 Bulletin 82/30**

(84) Designated Contracting States:
**BE CH DE FR GB IT LU NL SE**

(56) References cited:
**DE - A - 2 538 300**
**FR - A - 1 438 826**
**FR - A - 1 493 110**
**FR - A - 1 508 795**
**FR - A - 2 339 001**
**US - A - 3 594 238**
**US - A - 3 739 220**

**JOURNAL OF THE ELECTROCHEMICAL
SOCIETY, vol. 122, no. 10, 1975, D. E.
CARLSON "The deposition of tin oxide films
from a D.C. glow discharge", pages
1334—1337.**

(73) Proprietor: **PLASMA PHYSICS CORPORATION
Box 548 Locust Valley
Long Island New York 11560 (US)**

(72) Inventor: **Coleman, John H.
Plasma Physics Corporation Box 548
Locust Valley Long Island, N.Y. 11560 (US)**

(74) Representative: **Pears, David Ashley et al,
REDDIE & GROSE 16 Theobalds Road
London WC1X 8PL (GB)**

(56) References cited:
**SOLID STATE TECHNOLOGY, vol. 19, no. 6,
1976, R. S. ROSLER "A production reactor for
low temperature plasma-enhanced silicon
nitride deposition", pages 45—50.**

**SOLID STATE TECHNOLOGY, vol. 21, no. 1,
1978, H. FRITZSCHE "Amorphous
semiconducting silicon-hydrogen alloys", pages
55—60.**

**METALLOBERFLAECHE, vol. 30, no. 2, 1976,
W. OPPEL "Härtung von Metaloberflächen durch
Ionenbeschuss in der Glimmentladung", pages
64—68.**

Courier Press, Leamington Spa, England.

Method and apparatus for depositing semiconductor and other films.

Hydrogenated amorphous silicon films, hereinafter called a-Si, which are suitable for semiconductor applications have been prepared by a variety of techniques. Chittick, Alexander, and Sterling reported in the *Journal of the Electrochemical Society*, Vol. 116, No. 1 (Jan. 1969), pages 77—81, in an article entitled "The Preparation and Properties of Amorphous Silicon", that an inductively coupled, RF glow-discharge in silane ($SiH_4$) gas produced low-conductivity a-Si films that could be doped with both donor and acceptor impurities, thereby changing the a-Si conductivity over a wide range of values. More recently, a-Si films have been produced, by evaporating silicon in an atmosphere of hydrogen ($H_2$) and by sputtering silicon in an atmosphere of $H_2 + Ar$, which exhibited similar semiconductor characteristics to those films made from silane in a glow-discharge.

Several commercial projects related to the development of Schottky barrier solar cells using crystal, polycrystal, and amorphous semiconductor materials have been described in a recent book entitled *Twelfth IEEE Photovoltaic Specialists Conference* — 1976, published by the Institute of Electronic and Electrical Engineers Inc., New York, N.Y., 10017. On pages 893—895 of this book, Carlson et al. reported in an article entitled "Solar Cells Using Schottky Barriers on Amorphous Silicon" that he formed a solar cell by applying a transparent electrode with appropriate work-function to one side of an a-Si film and ohmic contact to the other. Also, this article stated output voltages increased initially by 100 mV when the thin metal electrode was evaporated in residual oxygen background in the vacuum system, producing a metal-insulator-semiconductor (MIS) structure. More recently, Carlson reported in Vol. 77-2, *Extended Abstracts, Fall Meeting, Atlanta, Georgia, Oct. 9—14, 1977* of the Electrochemical Society, Princeton, N.J., 08540, pages 791—792, that these MIS cells were generally unstable. Furthermore, Carlson reported that his electrodes were less than 0.02 $cm^2$ in area, too small a size for commercial use. Also, an article by Godfrey & Green in *Applied Physics Letters*, Vol. 31, No. 10 (15 Nov. 1977), pages 705—707, indicates that such small areas lead to erroneous data.

Glow-discharge coating processes stemming from the present invention are disclosed in U.S. Patents Nos. 3,068,283, 3,068,510 (Dec. 18, 1962) and 3,600,122 (Aug. 17, 1971). These processes generally relate to polymeric coatings which have resistivities greater than $10^{12}$ ohm-cm. Such high-resistivity coatings act as blocking capacitance in series with the glow discharge thereby assisting in regulation of coating uniformity. A high frequency field is used. However, neither 50 Hz—60 Hz- line transformers nor DC power supplies can be used with those prior processes.

It is also known to effect film deposition from a DC glow discharge stabilized in a weak field region which covers a substrate. See "The Deposition of Tin Oxide Films from a DC Glow Discharge" D. E. Carlson, Journal of the Electro-chemical Society, Volume 122, No. 10 (1975-10) pages 1334 to 1337. According to this proposal guard rings are employed to remove fringing fields to a region outside the electrode area proper so that the field over the substrate is rendered uniform.

Such an arrangement has to be operated with a higher field strength in order to establish the discharge between the substrate and the counter electrode. Any small imperfection on the substrate giving rise to a localised high field can then lead to avalanching with consequent damage to the deposited film. The method according to this reference is accordingly not suited to the production of perfect films extending over large substrate areas.

The object of the present invention is to provide a method and apparatus which enables a uniform film to be deposited over a larger area than heretofore, e.g. an area of several square centimetres.

The apparatus and method according to the invention are defined in claims 1 and 8 respectively. It has been found that the glow discharge will expand to extend over all the weak field region, even when the electrode spacing is too great for parts of this region to allow initiation of the glow discharge. Provided the gas pressure is correctly adjusted, the glow discharge is excluded only from the strong field region and when the weak field region extends over the whole substrate, uniform deposition can be achieved over the whole substrate.

The strong field region can be round the periphery of one electrode and in particular, for AC excitation, spaced, planar electrodes can then be employed with substrates on the outer surfaces of both electrodes.

Particularly when depositing semiconductor films, it has been found that simultaneous temperature control, by heating the substrate, is also advantageous as it is possible then to achieve a high dark resistivity for the film.

The method is particularly useful for producing semiconductor films which have electrical resistivities less than $10^{12}$ ohm-cm at room temperature, preferably between $10^{12}$ and $10^6$ ohm-cm. Such films act as a resistor in series with the glow discharge and DC or low frequency AC excitation can be employed. Means are described below for the treatment of a semiconductor surface to increase the Schottky barrier voltage when an active conducting coating is applied. Such treatment may be used on any semiconductor material, including crystal semiconductors which have conductivities of 100 and 0.01 ohm-cm and higher. This process and barrier treatment is particularly useful for producing a Schottky barrier solar cell.

Semiconductor material may be introduced from a solid source into the film being formed by glow-discharge deposition from the gas phase.

The invention will be described in more detail, by way of example, with reference to the accompanying drawings, wherein:—

Fig. 1 is a cross-sectional view of a first apparatus embodying the invention,

Figs. 2a to 2c are cross-sectional views of semiconductor devices produced by use of the apparatus,

Fig. 3 illustrates another embodiment of the invention in which multiple electrode points are employed to maintain a glow discharge,

Fig. 4 illustrates another embodiment in which the substrate is moved through the glow discharge,

Fig. 5a illustrates another embodiment which allows deposition on two substrates using an alternating field,

Fig. 5b is an explanatory diagram relating to Fig. 5a,

Fig. 6 illustrates another embodiment in which semiconductor material is evaporated through the glow discharge to stabilize the discharge and attain desired semiconducting properties,

Fig. 7 illustrates another embodiment in which semiconductor material is sputtered through the glow discharge to stabilize the discharge and attain desired semiconductor properties, and

Figs. 8 and 9 illustrate further devices made using the invention.

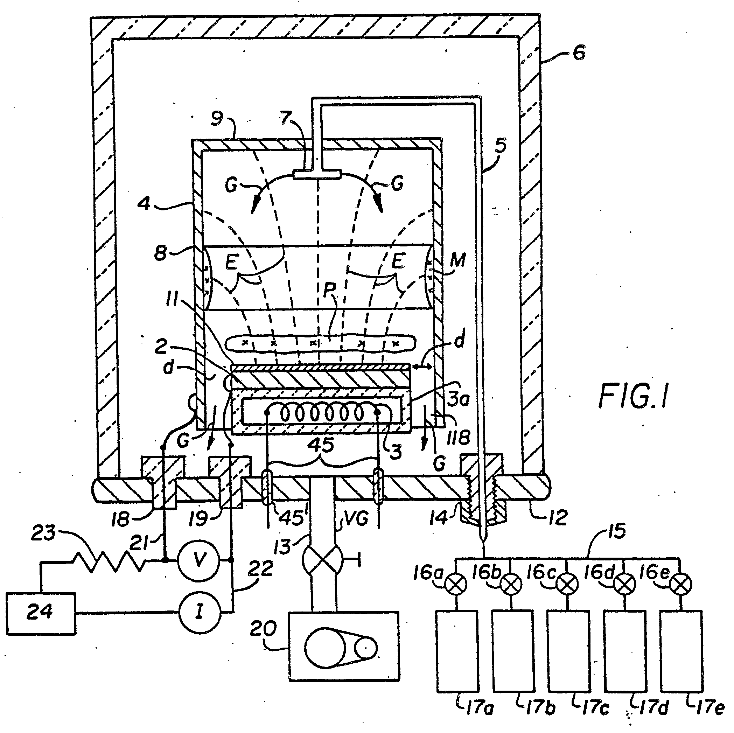

Referring to Fig. 1, a cross-sectional view is illustrated of a glow-discharge apparatus. The substrate is a 0.25 mm thick stainless steel plate 11 with rectangular dimensions of 75 mm × 100 mm supported by an electrode 2. A resistance heater 3 is embedded in a ceramic block 3a which supports and heats the electrode 2 and substrate 11. Substrate 11 is positioned in the opening of a box-form counter electrode 4 which has a rectangular cross-section of 100 mm × 125 mm defined by side walls 8 and a top 9. The top 9 is positioned at least 115 mm above the exposed surface of substrate 11. The electrodes 2 and 4 are positioned inside an enclosure 6 sealed on a base 12 by a gasket to form a gas-tight seal. A vacuum pump 20 is connected through a valve and nipple 13 to the base 12 to evacuate the enclosure 6. Gases G from tanks 17a—e are conducted through regulated needle valves 16a—e, a manifold 15 and a connector 14 through the base 12 into enclosure 6. Here the gases G are conducted through dielectric tubing 5 and a diffuser 7 inside the electrode 4. A gap 118 of say 12 mm between the walls 8 and the electrode 2 permits egress of gases G after passing through a glow discharge P. A gauge VG meters the pressure of the gases G in the enclosure 6 and is preferably of the capacitance-manometer type which is commercially available for use with corrosive, condensable gases in the range of $7.5 \times 10^{-6}$ to $72 \times 10^{-3}$ Pa (N/m²). A signal from the gauge VG may automatically regulate the valves 16 through a servo-mechanism to maintain a desired pressure. A potential V is applied between electrodes 2 and 4 from power supply 24 by leads 21, 22 connected through insulated electrical bushings 18, 19 sealed in the base 12. A protective resistor 23 prevents damaging spark currents. Voltage V and current 1 are metered as indicated. The resistance heater 3 is connected through leads 45 and insulating bushings 45' to a controlled power source (not shown).

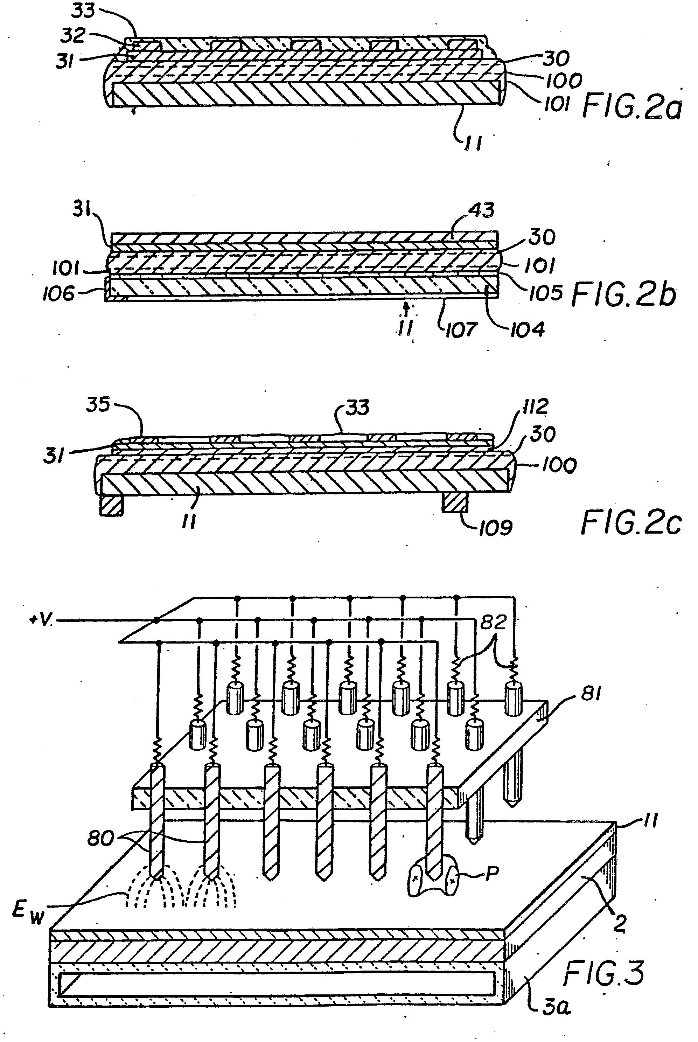

In operation, the enclosure 6 is evacuated by the pump 20 to a pressure below about $0.15 \times 10^{-3}$ Pa and back-filled with silane ($SiH_4$) from tank 17a by opening valve 16a. Valve 16a is adjusted to maintain the desired pressure in the enclosure 6 which, for example, may be $3.7 \times 10^{-3}$ Pa. Next a mixture of 10% phosphine ($PH_3$) in helium from tank 17b is admitted into manifold 15 where it mixes with the silane and flows through lines 5, 7 to raise the system pressure PG to about $7 \times 10^{-3}$ Pa. Electrodes 2 and 4 are cathode and anode and the potential difference V between the electrodes 2 and 4 is adjusted to about 530 volts, initiating a glow discharge and the current I is adjusted to about 5 mA to produce a heavily doped $n^+$ ohmic layer 101 on the substrate 11 (Fig. 2a). After maintaining the discharge for about 1 minute, the valve 16b is closed to shut off the flow of $PH_3$ and He, leaving silane alone. The uniformity and impurity level of the ohmic layer 101 is not as critical as that of the high-resistivity a-Si layer 100 which is deposited from the silane. Therefore the ohmic layer 101 may be deposited by conventional, doped chemical-vapour-deposition (CVD) or other techniques, prior to insertion of the substrate in the apparatus of Fig. 1.

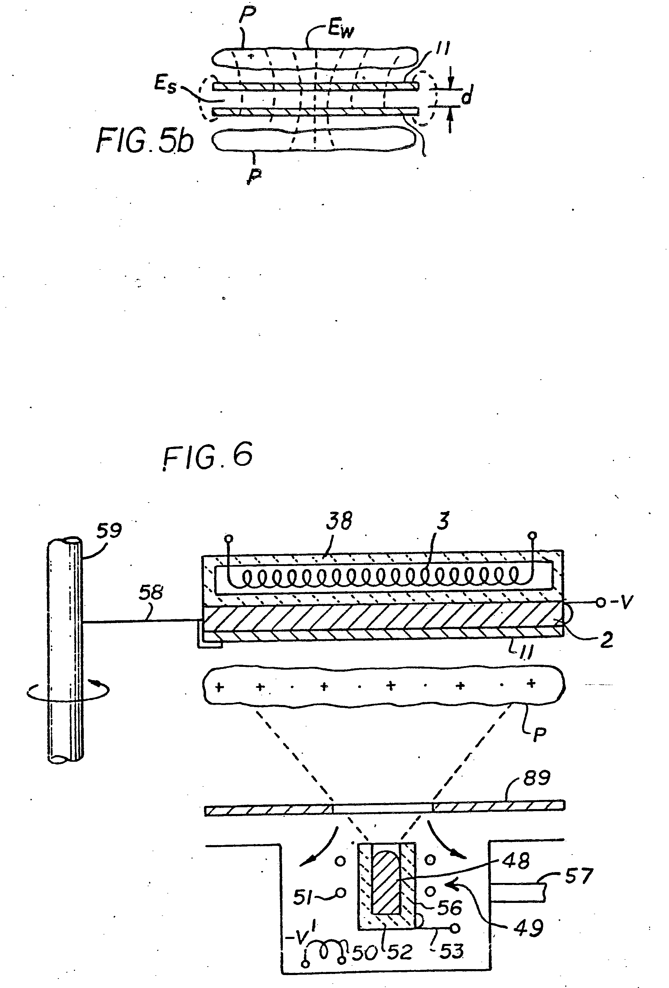

Next, the pressure PG of silane is adjusted to 2 to $3 \times 10^{-3}$ Pa to position a diffuse discharge P in the region above plate 11 and minimize the discharge in the region of closest separation $d$ between the electrodes 2 and 4. The discharge then occurs in the weaker region of the electric field E as will be discussed in more detail in connection with Fig. 5b. The discharge is maintained for 40 minutes at 5 mA with V in the range of 500—1500 V, depending on PG. After the desired thickness of the layer 100 on the substrate is attained, valve 16b is closed and the residual gases evacuated by the pump 20. Valve 16c on ammonia tank 17c is opened to admit $NH_3$ into the substrate region 1 to a pressure of about 3 Pa. A potential difference V is applied between the electrodes 2 and 4 of about 350 volts with a current of 5 mA to 10 mA (0.1 to 0.2 mA/cm²) to produce a glow discharge adjacent the coated substrate to deposit an ammonia-treated layer 30. Valve 16c is closed, the residual gases in enclosure 6 evacuated by the pump 20, and the enclosure 6 is back-filled with nitrogen from tank.17d (valve 16d) to purge unreacted silane. The valve 13 is closed, the jar 6 is raised to atmospheric pressure and lifted off and the substrate 11 is removed.

The temperature is controlled by way of the heater 3, a suitable temperature for the substrate 11 being about 300°C. This enables the layer 100 to have a high dark resistivity.

A deposit can also be formed at region M in Fig. 1. One of more substrates may be placed in this region and an alternating field employed or electrodes 2 and 4 connected as anode and cathode respectively. One or more heaters (not shown) adjacent electrode 4 would be employed to heat the substrates to the correct temperature.

Referring to Fig. 2a, the substrate 11 is a metal foil coated with a n⁺-doped a-Si layer 101, undoped 1—4 $\mu$ a-Si layer 100 and ammonia-treated layer 30. The coated substrate is then placed in a conventional vacuum-evaporator and coated with a high work-function, semi-transparent metal 31 (such as palladium) to a thickness of about 100 Å or less to complete a Schottky barrier. The conducting layer 31 is deposited to sufficient thickness to reduce its sheet resistance while not absorbing an inordinate amount of incident photons. A grid 32 of thicker metal, such as a silver-titanium alloy, is applied to reduce the series resistance of the semi-transparent electrode 31. Also, a top anti-reflection layer 33 such as $Si_3N_4$ with a thickness of about 1000 Å may be applied to the electrode 31 to reduce reflection loss under photon irradiation. Under test, the short-circuit current was measured to be about 2 mA/cm² and the open-circuit voltage was about 350 mV, with no anti-reflection coating and 50% reflection loss and no layer 30. When the layer 30 was added by the NH₃ discharge, the short-circuit current remained about 2 mA/cm² while the open-circuit voltage was measured to be greater than 600 mV — an increase in excess of 250 mV, again with no anti-reflection coating. Similar increases were found with other substrates as illustrated in the following drawings.

Referring to Fig. 2b, the substrate 11 is a glass sheet 104 coated with a transparent conducting coating 105 of the oxides of indium and tin (commercially available) which is inserted into the apparatus of Fig. 1 on the electrodes 2 with the conducting coating 105 facing the discharge and a conducting tab 106 contacting the electrode 2. Thereafter, the coating procedure is the same as that described in connection with Fig. 2a, in that the ohmic contact layer 101, a-Si layer 100 and NH₃-

treated barrier-layer 30 are produced sequentially. Also, using an evaporator, a Pd coating 31 is applied to complete the Schottky barrier and a thicker metallic layer 43 such as Ti—Ag applied to complete the contact. Since the semiconductor is illuminated through the glass plate 104, the electrode 43 may be opaque. An additional anti-reflection coating 107, such as an oxide of tantalum, may be applied to the glass. Although the glass substrate 104 serves as a useful protective material, the configuration of Fig. 2b produces somewhat less output than that of Fig. 2a since most charge carriers are generated at the ohmic surface where the incident photons impinge first rather than at the barrier where the output potential is developed.

P-type a-Si may be substituted for the n-type a-Si in the layer 100 by doping with a donor impurity during formation in the apparatus in Fig. 1. For example, during formation of the layer 100, the apparatus of Fig. 1 may be operated as described above except that diborane from tank 17e (valve 16e) is added to the silane flow from the tank 17a to dope the a-Si layer 100 to neutral or to p-type depending on the proportion of diborane in the silane. For example, 1 to 10% diborane from tank 17e may be added to dope the ohmic layer 101 to p⁺ level. For p-type a-Si, the active metal layer 31 is formed from a low work-function metal such as chromium or aluminium. In either case the layer 30 may be formed by NH₃-discharge to enhance the Schottky barrier.

The barrier height and open-circuit voltage of a-Si material may be increased by glow discharging in $N_2$ gas instead of NH₃. However, using the structure of Fig. 2a, when the layer 30 was formed from a $N_2$ discharge the increase in Voc amounted to only about 100 mV instead of 250 mV with NH₃. Also, nitrogen atoms produced an increased barrier. For example, using a commercial plasma torch producing a nitrogen atom beam to treat the surface of the layer 100, the open-circuit voltage increased by 150 mV after 15 minutes treatment. This value is somewhat larger than the direct $N_2$ discharge but smaller than the 250 mV under direct NH₃ glow discharge. Hydrazene proved more effective than $N_2$ alone. Air in an atomic beam was found to increase the Voc also; however, oxygen alone in a glow discharge formed a blocking layer. The discharge for producing the NH₃ treated layer 30 is not as critical as that for producing the a-Si layer 100 since the gases do not themselves form a film but combine with the coating 100 deposited previously. The glow discharge time limits are determined by the limiting thickness through which charge carriers can tunnel.

Referring to Fig. 2c, the substrate 11 is 0.09 mm thick stainless steel foil 102 reinforced with frame 109 which may be 1.5 mm thick or thicker, to prevent the foil from bending too sharply and damaging the a-Si film 100. Again, a barrier layer 30 is formed by discharge treatment in ammonia. However, an additional barrier layer 112 is added which may be antimony trioxide or titanium dioxide or other metallic oxides or nitrides having a thickness 50 Å or less to enhance the barrier height without blocking the desired charge carriers. In the case of $TiO_2$, the semi-transparent layer 31 may be nickel with a thickness 100 Å or less and may have an additional conducting layer of 50 Å or so of chromium (not shown). Contact fingers 35 and anti-reflective coating 33 are added to complete the photovoltaic Schottky barrier. The cells of Figs. 2a, b and c may be made with any semiconductor material having a photo-responsive barrier employing the apparatus of Fig. 1 or the modified apparatuses now to be described.

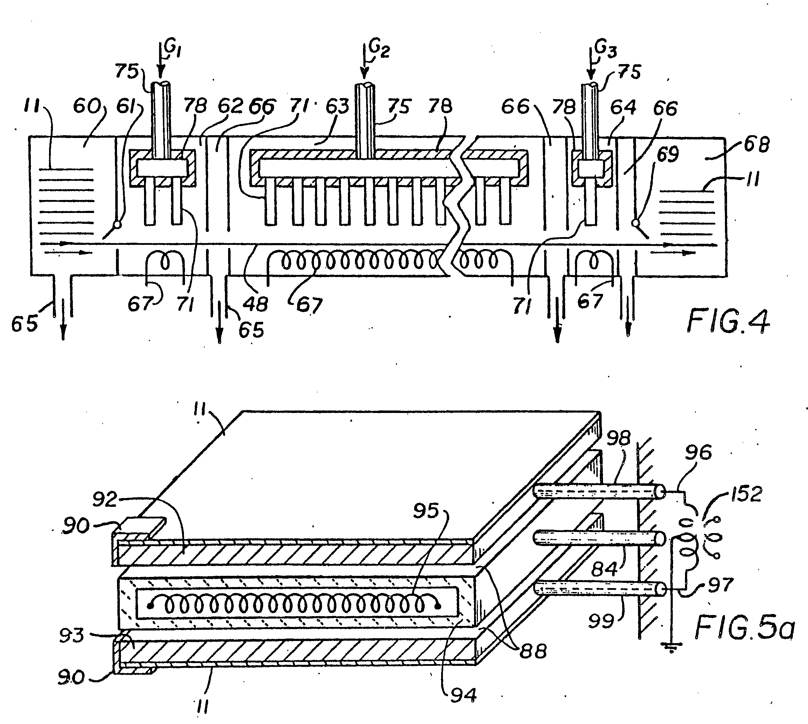

Referring to Fig. 3, the anode 4 of Fig. 1 is replaced by a set of cylindrical pins 80 supported by a dielectric holder 81. Each pin 80 is connected through a protective resistor 82 to +V. The dielectric holder 81 and resistors 42 are positioned at least 15 cm above the substrate to avoid deposition of conducting silicon material thereon. Typical operating conditions are similar to those described in connection with Fig. 1, except that the pressure and current density can be operated at higher values, say up to $15 \times 10^{-3}$ Pa and 1 mA/cm² and higher. Also, the substrate 11 can be moved through the discharge for continuous coating or may remain static. Again, the non-uniform electric field permits the discharge P to move nearer to or further from the pins 80 by adjustment of pressure while maintaining the discharge in the weaker field $E_w$.

In Fig. 3 the pins 80 have blunt points. Among other shapes are tapered pins or hollow cylinders facing the substrate 11. Silicon which is collected on the pins 80 is wasted material. However, by applying DC or DC plus AC with the pins 80 biased anodically, silicon collection is minimized. If the average current density over the substrate 11 is adjusted to be 0.2 mA/cm² and if the pins 80 are 1 cm apart, the resistors 82 may be around 100 k ohms for good regulation. Hollow pins are employed with a moving substrate in Fig. 4.

In Fig. 4, substrates 11 such as 1 m square stainless steel plates are conveyed in an evacuated enclosure on a conveyor rail 48 from a stack in an input chamber 60 to a stack in an output chamber 68, passing through an inlet airlock 61 and outlet airlock 69. Heaters 67 under the conveyor heat the substrates to the correct temperatures for each deposition stage. The substrates are connected to the cathodic terminal through the conveyor rail 48.

The ohmic layer 101 is deposited in a chamber 62 employing hollow pin electrodes 71 projecting from a hollow ceramic block 78 into which the gases $G_1$ required for depositing the ohmic layer are introduced via a conduit 75. The gases flow into the chamber 62, in particular into the glow discharge region through the hollow pins 71.

The a-Si layer 100 is deposited in a following chamber 63 from gases $G_2$, employing a similar structure and the barrier layer 30 is deposited from gaseous $G_3$ in chamber 64.

The enclosure is exhausted through various conduits 65 distributed along the length of the conveyor. The chambers are separated by barrier chambers 66 with which conduits 65 connect directly so as to establish low-pressure barrier zones which prevent gases from any chamber 62, 63, 64 leaking into another one of these chambers.

The size of each compartment 62, 63 and 64 is adjusted to provide such a residence time therein as will produce the desired coating thickness. The temperature of the substrates in the a-Si chamber 63 should be between 200° and 350°C, whereas the temperature in the ohmic layer chamber 62 can be considerably higher. The temperature in the $NH_3$ chamber 64 should be below about 300°C to avoid dehydrogeneration of the a-Si.

In operation, the airlock 61 is closed and the substrates are loaded in chamber 60, from which the air is then evacuated. Airlock 61 is opened and a commercial feeder mechanism (not shown) moves the substrates along the rail 48. Suitable mechanisms include individual moving armatures, endless conveyor belts and ultrasonic walkers. The substrates are unloaded and collected in a stacking mechanism (not shown) in compartment 68. Airlock 69 is closed and the coated substrates are removed to the evaporation system as described in connection with Fig. 1. Alternatively, the loading and unloading compartments 60 and 68 could be replaced with continuous seals, which are standard in the vacuum coating industry, to provide vacuum to air operation. Other suitable electrode configurations such as those now to be described may be used with moving substrates.

Referring to Fig. 5a, electrodes are illustrated which enable the use of AC and efficient collection on two substrates 11 of a substantial part of the a-Si. Parallel, rectangular electrodes 92, 93 hold stainless steel plates forming the substrates 11. End tabs 90 on the electrodes 92, 93 ensure good electrical contact to the substrates and may act as guide rails if the substrates are moved during deposition. Electrical contact to the electrodes 92, 93 is made by leads 96, 97 extending through ceramic insulators 98, 99. Leads 96, 97 are connected to a centre-tapped 60 Hz transformer 152. The electrodes may be supported by the insulators 98 and 99 and additional insulators (not shown). The electrodes are heated by a resistance heater 95 in a ceramic block 94, supported by a ceramic rod 84 between the electrodes. Small gaps 88 are maintained between the heater block 94 and the electrodes 92, 93 to avoid short-circuiting the electrodes 92, 93 through conducting Si, which deposits on the block 94. Also, the insulators 98, 99 and 84 should extend a distance greater than about 15 cm from the region of the electrodes under glow discharge. Input gases are distributed and exhausted from lines (not shown) as described in connection with Fig. 1.

In operation, silane gas G is admitted to a pressure of about 0.4 Torr (53 Pa) and, when the electrodes 92, 94 have a separation of 13 mm a RMS voltage of about 650 volts between the electrodes from the 60 Hz transformer 152 produces a current of 5 mA or about 0.2 mA/cm². These operating values are similar to those used with the DC supply of Fig. 1, except that each substrate 11 becomes cathodic alternately. As illustrated in Fig. 5$b$, the negative glow P extends over both substrates 11 in the weak electric field $E_w$ and, for a separation $d$ of 13 mm, a silane pressure of $2.6 \times 10^{-3}$ Pa eliminates all glow discharge in the strong field $E_s$. The actual operating pressure of $3 \times 10^{-3}$ Pa allows some discharge to the inactive ends. The pressure used during deposition of the ohmic layer and $NH_3$ treatment is determined separately.

Self-regulating SCR, or saturable reactor transformers can be used. Line frequencies (50—60 Hz) and audio frequencies to 20 KHz, which are supplied from inexpensive solid state supplies, are the preferred power sources.

Referring to Fig. 6, an e-beam evaporation source 49 (commercially available) having an electron gun 50, magnetic deflector 51, and crucible 52 with electrical contact 53, is used to evaporate polycrystalline silicon 48 through a glow discharge P on to a substrate 11. The substrate is composed of a stainless steel plate retained on an electrode 2, as discussed in connection with Fig. 1. However, the electrode 2 is attached to an arm 58 mounted on a shaft 59 which is rotated by a mechanism (not shown) to move the substrate from the coating region above the source 49 to a vacuum metallization region (not shown) to apply electrodes as described in connection with Figs. 2$a$, 2$b$ or the $TiO_2$ barrier layer, as described in connection with Fig. 2$c$. A baffle plate 89 and a high-capacity blower-pump connected to a conduit 59 permit a low pressure in the evaporator region and a higher pressure in the glow discharge region P around the substrate.

In operation, the crucible 56 may be grounded by the lead 53 and a potential $-V$ is applied to the substrate 11 to establish the glow discharge P. A negative potential $-V'$ may be applied to the e-beam source 50 to bombard and heat the crucible 56, or other suitable heat sources may be used to heat the crucible 56 to evaporate the silicon 48. Evaporated silicon passes through the glow discharge P where it is partially ionized and joins the silane ions to coat the surface of the substrate. The evaporated material stabilizes the glow discharge P and improves the semiconducting properties of the coating on the substrate. Gases G may be doped, undoped, or $NH_3$ as discussed in connection with Fig. 1. However, additional doping may be applied from the material in the crucible 56. Also, any of the structures illustrated in Figs. 2$a$, $b$, $c$ may be formed and ammonia may be added without operating the evaporation source 49.

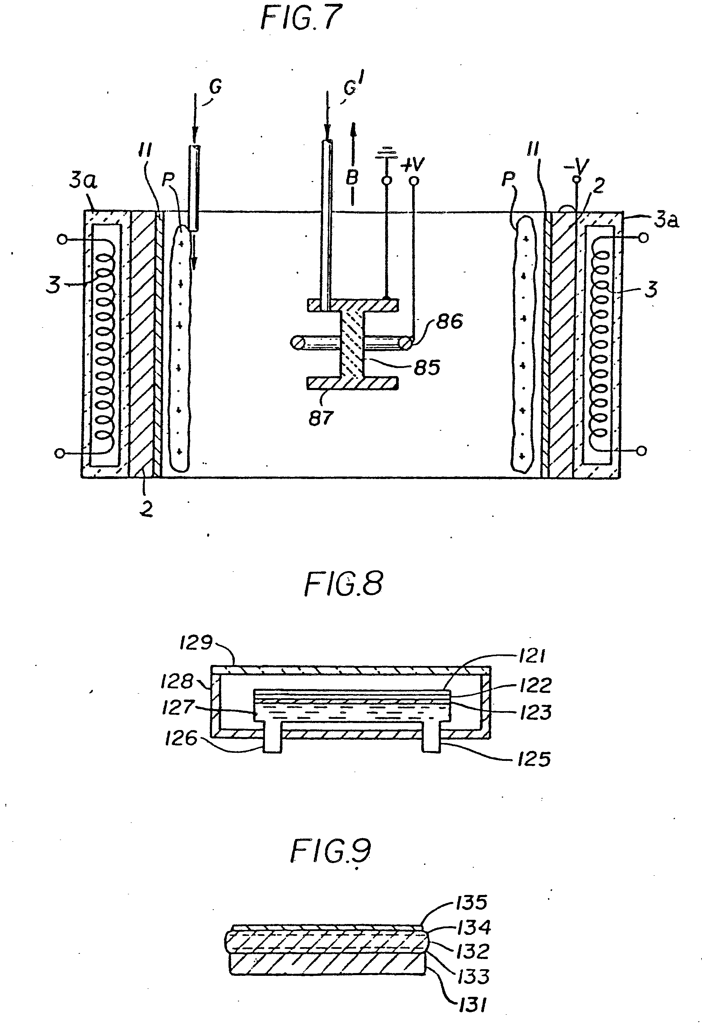

Referring to Fig. 7, a sputtering source 89 of the inverted magnetron type such as is described by J. H. Coleman, E. G. Linder and E. G. Apgar in *Proceedings of the IRE* (now IEEE) (july 1952), pages 818—828 has a cylindrical electrode 85 composed of polycrystalline silica, end plates 87 and anode ring 86. A magnetic field B has its principle component along the axis of the electrode 85. Substrate 11 on heated electrodes 2 are employed as in Fig. 1. The substrates are positioned to receive silicon sputtered from the electrode 85. A potential $-V$ maintains a glow discharge P in input gases G in the vicinity of the surface of plate 114.

In operation, gases G′ such as Ar or Ar + $H_2$ are injected between the magnetron electrodes 85, 86. A suitable potential, +V, on anode 86 and magnetic field B are maintained to sputter silicon on to the surface of the substrates. At the same time, a potential $-V$ is applied to the substrates to maintain the glow discharge P in the gases and sputtered silicon from the source 85. The potential $-V$ is maintained until the ions deposit on the substrates to form a film of the desired thickness. Silicon from the sputter source facilitates maintenance of a uniform glow discharge in the vicinity of the substrate and improves conductivity characteristics of Schottky barrier devices such as are illustrated in Figs. 2$a$, $b$, $c$.

Other silicon-hydrogen gases can be used in place of silane, such as $SiHCl_3$ and $SiH_2Cl_2$. Other semiconductor gases such as germane can be used to form hydrogenated amorphous germanium. Non-hydrogenated semiconductors can also be used, including the binary allows of gallium. For example, trimethylgallium gas glow-discharged with several other gases forms semiconductor films (with arsene, forms GaAs; with $NH_3$, forms GaN; and with $PH_3$, forms GaP).

Referring to Fig. 8, a solar thermal-collector is shown with a 1 $\mu$m a-Si film 121 and a-Ge film 122 coated on the front of a stainless steel plate 123 which faces the solar radiation. Water is circulated by input tubing 125 and output tubing 126 through an enclosure 127 where it contacts the rear of the plate 123. Transparent glazing 129 and an enclosure 128 hold and insulate the plate assembly which is heated by the solar radiation.

The visible solar radiation component is absorbed in the a-Si coating 121. The infra-red component of the solar radiation passes through the a-Si coating 121 and is absorbed in the a-Ge coating 122. The plate 123 preferably has a polished or metallized surface with low infra-red emissivity for radiation wavelengths above say 2 $\mu$m, which would otherwise be radiated from the solar-heated plate 123 itself. Thus, the a-Si absorbs visible radiation whereas a-Ge, which has a smaller band gap than a-Si, absorbs the infra-red component. The a-Si, a-Ge films 121, 122 in combination yield close to the ideal characteristics of a solar thermal-collector-high absorptivity and low infra-red emissivity. Any of the processes described above may be used to coat the a-Si and a-Ge layers 121, 122. Also, the coated plate 123 may be used separately without glazing 129 and box 128 in a focused collector. It should be noted that both a-Si and a-Ge formed in the described apparatus absorb more efficiently than crystalline Si or Ge, and cost substantially less than crystals. Another application of films made with the process is shown in Fig. 9.

A p-n junction is shown with a stainless steel substrate 131 coated with a-Si film 132 which has a heavily doped $n^+$ layer 133 making ohmic contact with the plate 131 as described in connection with Fig. 1. A p (or $p^+$) layer 134 is added to the coating 132 forming a p-n junction. The p layer 134 is formed by means of a glow-discharge in 1% diborane in helium in the apparatus of Fig. 1 carried out over the top surface of the a-Si film 132, thereby converting the top layer of the intrinsic n-type a-Si film to p-type by boron doping. A top chromium contact layer 135 may be semi-transparent, if the device of Fig. 9 is to be operated as a solar cell. Alternative substrate surfaces include alloys of antimony and gold.

Other applications of the coating process and the improved barrier layer are field-effect-transistors FET, insulated-gate-field-effect-transistors and charge-coupled-devices.

## Claims

1. Apparatus for depositing films upon a substrate by decomposition of a gaseous material, from which the film is deposited, by a glow discharge, wherein the substrate (11) is disposed upon a first of two electrodes (2) and an alternating or direct electric field is established between the electrodes (2, 4) to create the glow discharge with a weak field region over the substrate, characterised in that the two electrodes (2, 4) are so shaped and positioned relative to each other that the electric field is spatially non-uniform over the substrate so that there are stronger and weaker field regions, and means for adjusting the pressure of the gaseous material to a value such that the glow discharge is moved into and stabilized in the weaker field region for uniform deposition therefrom on to the substrate.

2. Apparatus according to claim 1, wherein the electrodes (2, 4) are separated from each other by a small gap (d) around the periphery of one electrode, thereby establishing the strong field region, while the distance over which lines of force extend from the inner area of the first electrode to the second electrode is substantially greater than the small gap, thereby establishing the weak field region.

3. Apparatus according to claim 2, for use with AC excitation, wherein two substrates (11) are supported on the outer surfaces of two spaced, planar electrodes (92, 93).

4. Apparatus according to claim 1, wherein the second electrode comprises an array of elongated electrodes (80 or 71) directed towards the first electrode (2).

5. Apparatus according to any of claims 1 to 4, comprising means (3) for heating the substrate to control the deposition temperature.

6. Apparatus according to any of claims 1 to 5, comprising means (85, 86) for sputtering material through the glow discharge region.

7. Apparatus according to any of claims 1 to 5, comprising thermal means (49) for evaporating material through the glow discharge region.

8. A method of depositing a film upon a substrate from a gaseous material subjected to decomposition at low pressure from a weak field region in an alternating or direct current glow discharge, characterised in that the glow discharge is established by a spatially non-uniform electric field such as to provide a stronger field region as well as a weaker field region over the substrate, and the pressure of the gaseous material is so adjusted that the glow discharge is moved into and stabilized in the weaker field region and uniform deposition therefrom on to the substrate is effected.

9. A method according to claim 8, for depositing a semiconductor film, wherein the substrate is heated to a temperature such that the film has a high dark resistivity.

10. A method according to claim 9, wherein semiconductor material is additionally evaporated or sputtered through the glow discharge to improve the characteristics of the semiconductor film.

11. A method according to claim 9 or 10, wherein the semiconductor film is deposited on a metal film.

12. A method according to claim 9, 10 or 11, wherein a nitride layer is deposited on the semiconductor film.

13. A method according to any of claims 9 to 12, wherein the semiconductor film is amorphous silicon.

14. A method according to any of claims 9 to 13, wherein the glow discharge is employed to introduce a dopant into the semiconductor film.

15. A method according to any of claims 8 to 14, wherein the substrate is moved through the glow discharge while the film is being deposited.

16. A method of producing a semiconducting film on the surface of a substrate in an evacuated enclosure, comprising ionizing a gaseous, film-forming material at subatmospheric pressure, establishing a spatially non-uniform electric field over the surface, the electric field having a weak field region extending over the surface, and so controlling the pressure as to collect the ionized material on the said surface adjacent the weak field region to produce a uniform semiconducting film on the surface.

17. A method of making a semiconductor device according to any of claims 8—16, wherein a coating of amorphous silicon is deposited by establishing a glow discharge in a mixture of thermally generated silicon-bearing vapour and a hydrogen-bearing gas.

### Revendications

1. Dispositif pour le dépôt de couches sur un substrat par décomposition d'une matière gazeuse, à partir de laquelle la couche est déposée, par une décharge luminescente, dans lequel le substrat (11) est disposé sur une première de deux électrodes (2) et un champ électrique alternatif ou continu est établi entre les électrodes (2, 4) afin de créer la décharge luminescente avec une région à champ faible sur le substrat, caractérisé en ce que les deux électrodes (2, 4) ont des formes telles et sont placées de telle manière l'une par rapport à l'autre que le champ électrique soit spatialement non-uniforme sur le substrat de façon qu'il y ait des régions à champ plus intense et à champ plus faible, et des moyens sont prévus pour régler la pression de la matière gazeuse à une valeur telle que la décharge luminescente soit déplacée vers la région à champ plus faible et stabilisée dans cette région pour dépôt uniforme sur le substrat.

2. Dispositif selon la revendication 1, dans lequel les électrodes (2, 4) sont séparées l'une de l'autre par un petit espace libre (d) autour de la périphérie d'une électrode, établissant ainsi la région à champ intense, tandis que la distance sur laquelle les lignes de force s'étendent depuis la surface intérieure de la première électrode jusqu'à la deuxième électrode est sensiblement plus grande que le petit intervalle, établissant ainsi la région à champ faible.

3. Dispositif selon la revendication 2, pour utilisation avec excitation par courant alternatif, dans lequel deux substrats (11) sont supportés sur les surfaces extérieures de deux électrodes planes espacées (92, 93).

4. Dispositif selon la revendication 1, dans lequel la deuxième électrode comprend un groupe d'électrodes allongées (80 ou 71) dirigées vers la première électrode (2).

5. Dispositif selon l'une quelconque des revendications 1 à 4, comprenant des moyens (3) pour chauffer le substrat de manière à régler la température de dépôt.

6. Dispositif selon l'une quelconque des revendications 1 à 5, comprenant des moyens (85, 86) pour la pulvérisation cathodique d'une matière à travers la région de la décharge luminescente.

7. Dispositif selon l'une quelconque des revendications 1 à 5, comprenant des moyens thermiques (49) pour l'évaporation d'une matière à travers la région de la décharge luminescente.

8. Un procédé pour le dépôt d'une couche sur un substrat à partir d'une matière gazeuse soumise à une décomposition à basse pression dans une région à champ faible dans une décharge luminescente en courant alternatif ou continu, caractérisé en ce que la décharge luminescente est établie par un champ électrique spatialement non-uniforme de manière à fournir une région à champ assez intense ainsi qu'une région à champ assez faible sur le substrat, et la pression de la matière gazeuse est réglée de manière que la décharge luminescente soit déplacée vers la région à champ assez faible et stabilisée dans cette région et qu'un dépôt uniforme soit effectué sur le substrat.

9. Un procédé selon la revendication 8, pour le dépôt d'une couche d'un matériau semi-conducteur, dans lequel le substrat est chauffé à une température telle que la couche ait une haute résistivité d'obscurité.

10. Un procédé selon la revendication 9, dans lequel un matériau semi-conducteur est en outre évaporé ou soumis à une pulvérisation cathodique à travers la décharge luminescente pour améliorer les caractéristiques de la couche semi-conductrice.

11. Un procédé selon la revendication 9 ou 10, dans lequel la couche de matériau semi-conducteur est déposée sur une couche de métal.

12. Un procédé selon la revendication 9, 10 ou 11, dans lequel une couche de nitrure est déposée sur la couche de matériau semi-conducteur.

13. Un procédé selon l'une quelconque des revendications 9 à 12, dans lequel la couche de matériau semi-conducteur est constituée de silicium amorphe.

14. Un procédé selon l'une quelconque des revendications 9 à 13, dans lequel la décharge luminescente est utilisée pour introduire un dopant dans la couche de matériau semi-conducteur.

15. Un procédé selon l'une quelconque des revendications 8 à 14, dans lequel le substrat est déplacé à travers la décharge luminescente tandis que la couche est déposée.

16. Un procédé de production d'une couche de matériau semi-conducteur sur la surface d'un substrat dans une enceinte mise sous vide, selon lequel on ionise une matière gazeuse feuillogène sous pression réduite, on établit un champ électrique spatialement non-uniforme sur la surface, le champ ayant une région à champ faible s'étendant sur la surface, et on règle la pression de manière à recueillir la matière ionisée sur la surface près de la région à champ faible afin de produire sur la surface une couche semi-conductrice uniforme.

17. Un procédé de production d'un dispositif à semi-conducteurs selon l'une quelconque des revendications 8 à 16, dans lequel on dépose un revêtement de silicium amorphe en établissant une décharge luminescente dans un mélange de vapeur contenant du silicium produite thermiquement et d'un gaz contenant de l'hydrogène.

**Patentansprüche**

1. Vorrichtung zum Abscheiden von dünnen Schichten auf ein Substrat durch Zersetzung eines gasförmigen Materials, aus dem die dünne Schicht abgeschieden wird, durch eine Glimmentladung, wobei das Substrat (11) auf einer ersten von zwei Elektroden (2) angeordnet und zwischen den Elektroden (2, 4) ein elektrisches Wechseloder Gleichstromfeld hergestellt wird, um die Glimmentladung mit einem Schwachfeldbereich über dem Substrat zu erzeugen, dadurch gekennzeichnet, daß die beiden Elektroden (2, 4) derart geformt und relativ zueinander angeordnet sind, daß das elektrische Feld räumlich ungleichmäßig über das Substrat verteilt ist, so daß es stärkere und schwächere Feldbereiche gibt, und daß Mittel zum Einstellen des Druckes des gasförmigen Materials auf einen derartigen Wert vorgesehen sind, daß die Glimmentladung in den schwächeren Feldbereich hinein bewegt und dort stabilisiert wird, um eine gleichmäßige Abscheidung aus dem gasförmigen Material auf das Substrat zu erzielen.

2. Vorrichtung gemäß Anspruch 1, dadurch gekennzeichnet, daß die Elektroden (2, 4) voneinander durch eine schmale Lücke (d) um den Umfang einer Elektrode herum getrennt werden, wodurch der Starkfeldbereich hergestellt wird, während die Entfernung, über die sich Kraftlinien aus dem inneren Bereich der ersten Elektrode zur zweiten Elektrode erstrecken, wesentlich größer als die schmale Lücke ist, wodurch der Schwachfeldbereich hergestellt wird.

3. Vorrichtung gemäß Anspruch 2 zur Verwendung mit Wechselstromerregung, dadurch gekennzeichnet, daß zwei Substrate (11) auf den Außenflächen zweier voneinander beabstandeter planarer Elektroden (92, 93) gehaltert sind.

4. Vorrichtung gemäß Anspruch 1, dadurch gekennzeichnet, daß die zweite Elektrode eine Anordnung länglicher Elektroden (80 oder 71) umfaßt, die auf die erste Elektrode (2) zu gerichtet sind.

5. Vorrichtung gemäß einem der Ansprüche 1 bis 4, dadurch gekennzeichnet, daß sie Mittel (3) zum Erhitzen des Substrates zur Steuerung der Abscheidungstemperatur umfaßt.

6. Vorrichtung gemäß einem der Ansprüche 1 bis 5, dadurch gekennzeichnet, daß sie Mittel (85, 86) zum Zerstäuben von Material durch den Bereich der Glimmentladung umfaßt.

7. Vorrichtung gemäß einem der Ansprüche 1 bis 5, dadurch gekennzeichnet, daß sie thermische Mittel (49) zum Verdampfen von Material durch den Bereich der Glimmentladung umfaßt.

8. Verfahren zum Abscheiden eine dünnen Schicht aus einem gasförmigen Material auf ein Substrat, wobei das gasförmige Material bei niedrigem Druck aus einem Schwachfeldbereich in einer Wechsel- oder Gleichstrom-Glimmentladung der Zersetzung unterworfen wird, dadurch gekennzeichnet, daß die Glimmentladung durch ein räumlich ungleichförmiges elektrisches Feld erzeugt wird, so daß über das Substrat ein stärkerer sowie ein schwächerer Feldbereich vorgesehen wird, und daß der Druck des gasförmigen Materials derart eingestellt wird, daß die Glimmentladung in den schwächeren Feldbereich bewegt und dort stabilisiert wird sowie eine gleichförmige Abscheidung daraus auf das Substrat bewirkt wird.

9. Verfahren gemäß Anspruch 8 zum Abscheiden einer dünnen Halbleiterschicht, dadurch gekennzeichnet, daß das Substrat auf eine derartige Temperatur erhitzt wird, daß die dünne Schicht einen hohen spezifischen Dunkelwiderstand aufweist.

10. Verfahren gemäß Anspruch 9, dadurch gekennzeichnet, daß das Halbleitermaterial außerdem durch die Glimmentladung verdampft oder versprüht wird, um die Eigenschaften der dünnen Halbleiterschicht zu verbessern.

11. Verfahren gemäß Anspruch 9 oder 10, dadurch gekennzeichnet, daß die dünne Halbleiterschicht auf einer dünnen Metallschicht abgeschieden wird.

12. Verfahren gemäß Anspruch 9, 10 oder 11, dadurch gekennzeichnet, daß eine Nitridschicht auf der dünnen Halbleiterschicht abgeschieden wird.

13. Verfahren gemäß einem der Ansprüche 9 bis 12, dadurch gekennzeichnet, daß die dünne Halbleiterschicht aus amorphem Silicium besteht.

14. Verfahren gemäß einem der Ansprüche 9 bis 13, dadurch gekennzeichnet, daß die Glimmentladung dazu verwendet wird, um ein Dotierungsmittel in die dünne Halbleiterschicht einzubringen.

15. Verfahren gemäß einem der Ansprüche 8 bis 14, dadurch gekennzeichnet, daß das Substrat durch die Glimmentladung bewegt wird, während die dünne Schicht abgeschieden wird.

16. Verfahren zum Erzeugen einer dünnen halbleitenden Schicht auf der Oberfläche eines Substrates in einer evakuierten Umhüllung, dadurch gekennzeichnet, daß man ein gasförmiges, filmbildendes Material bei unter atmosphärischem Druck ionisiert, ein räumlich ungleichförmiges elektrisches Feld über der Oberfläche herstellt, das einen Schwachfeldbereich aufweist, der sich über die Oberfläche erstreckt, und den Druck derart steuert, daß das ionisierte Material auf der Oberfläche angrenzend an den Schwachfeldbereich gesammelt wird und auf diese Weise eine gleichförmige halbleitende Schicht auf der Oberfläche erzeugt wird.

17. Verfahren zur Herstellung einer Halbleitereinrichtung gemäß einem der Ansprüche 8 bis 16, dadurch gekennzeichnet, daß eine Beschichtung aus amorphem Silicium durch Erzeugen einer Glimmentladung in einem Gemisch aus thermisch erzeugtem siliciumhaltigen Dampf und einem wasserstoffhaltigen Gas abgeschieden wird.

0 002 383

FIG.I

FIG.2a

FIG.2b

FIG.2c

FIG.3

FIG.4

FIG.5a

3

**0 002 383**

FIG.5b

FIG. 6

4

## FIG.7

## FIG.8

## FIG.9